# EUROPEAN PATENT SPECIFICATION

(11) **EP 2 154 539 B1**
(45) Date of publication and mention of the grant of the patent: **13.04.2011**
(21) Application number: 08162387.8
(22) Date of filing: 14.08.2008
(51) Int. Cl.: G01R 11/24, G01R 31/40

(54) **Consumption meter with magnetic field detector**
Verbrauchsmesser mit Magnetdetektor
Compteur de consommation avec capteur magnétique

(43) Date of publication of application: 17.02.2010
(73) Proprietor: KAMSTRUP A/S, 8660 Skanderborg (DK)
(72) Inventor: Hansen, Gorm Bass, 8722, Hedensted (DK)
(74) Representative: Plougmann & Vingtoft A/S

(56) References cited:
- EP-A- 1 065 508
- DK-U3- 200 600 285
- US-A- 4 707 679
- US-A- 5 973 941

## Description

### Field of the Invention

The invention relates to the field of consumption meters, such as electric meters, gas meters, heat meters and water meters. Especially, the invention relates to consumption meters suited for detecting influence of an external magnetic field.

### Background of the invention

A consumption meter for measuring a consumed quantity of such as electricity, gas, heat or water, can be powered by a power supply which serves to transform the rather high AC voltage on the electricity net to a DC voltage suitable for electronic circuits of the meter. An example of such meter is described in Danish Utility Model application DK 2006 00285 U3.

Consumption meters often use power supplies based on transformers and coils with iron cores or ferrite cores. However, such consumption meters are rather vulnerable to influence of a strong external magnetic field, since such strong external magnetic field will destroy the transformer and coil effects and thus cause the power supply function to fail. This implies that the whole meter will fail due to the supply voltage falling below the acceptable limit for the meter circuits to function if a strong magnet is applied near the meter. This introduces a possible way of influencing the meter function with the purpose of causing an erroneous low measured consumption quantity. Therefore providers of electricity, gas, heat, water and the like require that their consumption meters are magnetically immune, In order to eliminate such way of cheating with the purpose of causing the meter to register a too low consumed quantity. Some providers require that their consumption meters are capable of detecting an external magnetic field, in order to at least detect if the meter has been exposed to magnetic intrusion. If magnetic intrusion is detected, then the meter may under some conditions avoid meter failure if the meter switches into a low power mode where only the most crucial measurement and calculator circuits are active. Hereby a partly reduced function of the power supply can be overcome and the most vital function of the meter can be maintained.

Consumption meters capable of detecting a magnetic field are known, and they are based on detecting a magnetic field by means of a Hall sensor or a reed relay. However, such meters suffer from the disadvantage that the detector transducer necessarily will be positioned physically separate from the inductive component in the meter that is actually influenced by the magnetic field. Thus, the magnetic field sensed by the detector transducer will not necessarily represent the magnetic field influencing the sensitive inductive component in the meter. This means that in some cases it will be possible to introduce an external magnet causing the meter to fail while the sensed magnetic field does not exceed an expected critical threshold.

EP 1 065 508 A2 discloses an electrical utility meter with a housing and a tamper protection circuit secured to the housing. The tamper detection circuit is operable to detect an interruption of the electrical power to the housing input and determine whether the housing is in an uninstalled position when an interruption of the electrical power to the housing input is detected.

US 5,973,941 discloses an electronic electricity meter comprising a measuring circuit and a power supply circuit. The power supply circuit comprises a main capacitor and a transformer controlled by a switching mode circuit. The transformer has an additional winding between the core and the primary and an integrator circuit rated to supply at its output a voltage image substantially proportional to the main capacitor voltage.

### Summary of the invention

Thus, according to the above explanation, it is an object of the present invention to provide a consumption meter capable of detecting magnetic intrusion with a high degree of security in detecting magnetic intrusion causing malfunction of the meter.

According to a first aspect, the invention provides a consumption meter for measuring a quantity value corresponding to a consumed quantity as in claim 1.

Due to the special magnetic field detector detecting a magnetic field related to the electrical switching operation of the switch mode power supply, such as at one or more frequency components characteristic of the switching operation, the consumption meter will be able to detect the actual magnetic influence of the switch mode power supply rather than trying to detect the magnetic field applied which will typically be a static magnetic field rather than an alternating magnetic field. In other words, the damaging effect of an intruding magnet is detected rather than the magnetic field generated by the intruding magnet. This implies that the problem of precisely detecting any intruding magnetic field is eliminated. Thereby it is possible to precisely detect when a magnetic intrusion is applied which will influence the function of the switch mode power supply to a degree which is critical with respect to the vital meter function. Thus, a high degree of security for detection of a magnetic intrusion critical for malfunction of the meter is obtained.

With a specific position of the detector coil, it is easy to relate the response from the detector coil with the function of the switch mode power supply so as to be able to determine if the magnetic intrusion is critical based solely on the response from the detector coil. Further, the magnetic field detector can be implemented with simple low cost components which are easily integrated into an existing meter.

In a preferred embodiment, the detector coil is positioned in relation to an inductive element, such as a transformer, forming part of the switch mode power supply so as to sense a magnetic field radiated from the inductive element. In this way the detector coil can sense the magnetic dispersion field at the switching frequency radiated from the inductive element, e.g. transformer, of the switch mode power supply.

In a preferred embodiment, the detector circuit may be arranged to generate an output signal upon detection of a level of the electric signal in a frequency range including at least one frequency component related to the switching operation of the switch mode power supply exceeding a predetermined threshold. This can easily be implemented by simple circuit elements, e.g. based on a comparator. The detector circuit may apply the electric signal from the detector coil to a tuning circuit tuned to a frequency range characteristic for the switching operation of the switch mode power supply. Such tuning circuit will help to focus subsequent signal processing to the relevant part of the detector signal, namely characteristic switching frequency components, e.g. one single component or a frequency range covering two or more components. Further, such tuning circuit can be implemented by simple passive elements. Especially, an output from the tuning circuit may be applied to a comparator arranged to compare a level of the output from the tuning circuit to a predetermined level.

The meter may include a filter arranged to suppress spectral components in the electric signal away from a frequency range characteristic for the switching operation of the switch mode power supply. This will help to reduce influence of the spectral components away from the switching frequency, which may even enable a simple level detection to suffice for determining between a critical and a non-critical magnetic intrusion.

In some embodiments, the meter may include a control circuit, e.g. powered by the switch mode power supply, the control circuit being operationally connected to the detector circuit, and wherein the control circuit is arranged to initiate an action in response to a change in the electric signal from the detector coil being detected by the detector circuit. Such embodiments are suited for initiating an action when an intruding magnet is detected, either a pure passive action such as storing in memory that an intrusion has been detected, or by initiating an action serving to remedy the intrusion. The control circuit may be arranged to disconnect one or more auxiliary circuits from the switch mode power supply in response to a change in the electric signal from the detector coil. Here 'auxiliary circuit' is to be understood as circuits other than the measurement circuit, the calculator circuit and preferably also circuits related to magnetic detection. By switching off such circuits, power is saved, and the vital operation of the meter may be maintained during magnetic intrusion where the power supply has a reduced power capacity. In such embodiment, e.g. a power consuming Radio Frequency communication unit is preferably switched off in order so save power to the vital measurement circuit and calculator circuit. When the electric signal from the detector coil indicates that a magnetic intrusion has stopped, all circuits can be switched on again. The control circuit may be arranged to generate an alarm signal, such as a visual or audible alarm signal, in response to a change in the electric signal from the detector coil. The control circuit may be arranged to interrupt supply of the consumption entity in response to a change in the electric signal from the detector coil, and thus the provider can stop supply of electricity, heat, gas or water to the consumer when the meter is influenced and possibly completely out of function. Further, the meter may be arranged to store data in a memory, e.g. a log, of the meter indicating that a change in the electric signal from the detector coil has been detected, e.g. such data may include a time information associated therewith. Hereby it is possible to later request a status, e.g. remotely, and thereby experience that a magnetic intrusion has most likely taken place.

In preferred embodiments, the meter includes a communication module arranged to transmit a data value representing the consumed quantity. The communication module may include a wireless Radio Frequency transmitter. The communication module may be arranged to transmit an alarm signal upon change in the electric signal from the detector coil being detected, hereby being able to inform the provider that intrusion is taking place, and the provider can then take any appropriate action. Specifically, the communication module may be arranged for one or more of: communication via the GSM net, powerline communication, and communication with the internet.

The consumption meter may be such as: 1) an electricity meter arranged to measure a quantity of electric energy, 2) a heat meter arranged to measure a quantity of heat, 3) a water meter arranged to measure a quantity of water, or 4) a gas meter arranged to measure a quantity of gas.

In a second aspect, the invention provides a method for detecting an external magnetic influence of a consumption meter arranged to measure a quantity of a consumption entity as in claim 15.

It is appreciated that any advantage mentioned for the first aspect applies as well for the second aspect. Further, any sub aspect mentioned in connection with the first aspect may in any way be combined with the second aspect.

### Brief description of drawings

In the following, the invention will be described in more details by referring to embodiments illustrated in the accompanying drawings, of which
Fig. 1 illustrates a consumption meter embodiment, and
Fig. 2 illustrates an example of a detector circuit,
Fig. 3 illustrates another example of a detector circuit.

### Detailed description of the invention

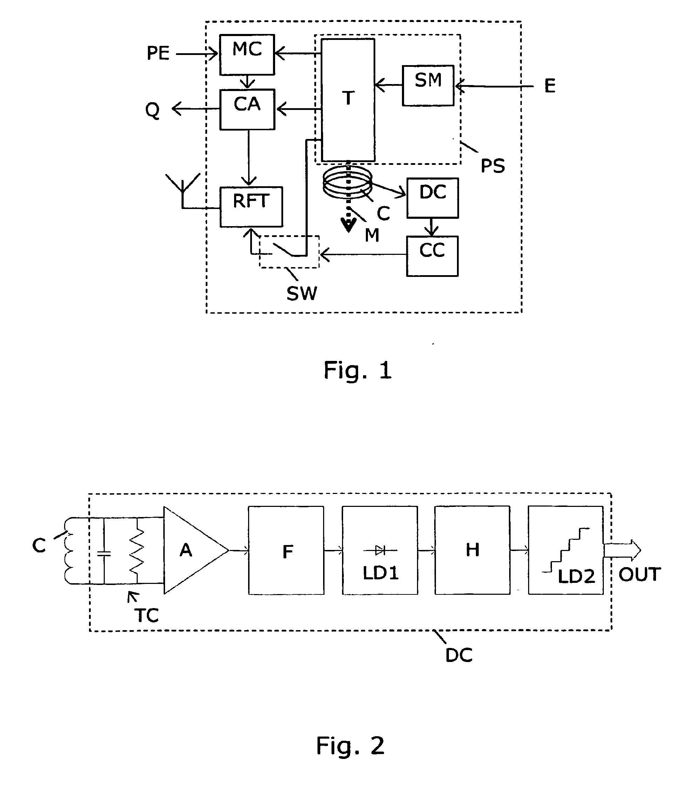

Fig. 1 illustrates selected parts of a consumption meter embodiment including a measurement circuit MC arranged to perform a measurement of a physical entity PE, e.g. electricity, which is consumed by a consumer. A calculator circuit CA calculates a quantity value Q representing the consumed quantity of the physical entity, e.g. in the form of data representing a value of consumed kWh, in response to the measurement data from the measurement circuit MC. The measurement circuit MC and the calculator circuit CA are powered by a switch mode power supply PS.

The power supply PS converts electricity E from an energy source, e.g. the 50 Hz, 230 V electricity net, to a lower voltage suitable to drive the electronics forming the measurement circuit MC and the calculator circuit CA. Further, the power supply PS powers a Radio Frequency transmitter RFT arranged to receive data from the calculator circuit CA and transmit this data as a wireless Radio Frequency signal. The power supply includes a switch mode circuit SM operating according to a switching scheme, i.e. involving switching of electronic switches at one or more characteristic switching frequency components, typically spectrally located at rather high frequencies, such as in the order of 100 kHz. The switch mode circuit SM generates an output signal with dominating spectral components at these characteristic switching frequency components and with a high voltage level. This output signal is applied to a transformer T that converts the high voltage level to a suitable level for subsequent smoothing to a DC voltage suitable for driving electronic circuits.

A detector coil C of electrically inductive material, e.g. copper, is positioned in relation to the transformer T so as to inductively detect the magnetic dispersion field M in the air generated by the transformer T at the characteristic frequency components related to the switching operation of the switch mode circuit SM. When influenced by a strong magnetic field, such as by intrusion in an attempt to cheat, the inductive properties of the core material of the transformer T will change. Accordingly, the transformer T will exhibit a reduced transforming efficiency. This also means that the magnetic dispersion field M at the characteristic switching operation frequency components will change, and this change will then be detected by the detector coil C. Typically it will be such that only a very weak magnetic dispersion field M can be observed from the transformer T during normal operation, while by magnetic intrusion, the magnetic dispersion field M increases significantly. In this way the detector coil C does not directly measure the magnetic intrusion field, which is normally a static field, but rather its effect on the transformer T performance of the switch mode power supply PS. Hereby a measure of the impact on the power supply is obtained in a rather simple way. The detector coil C is electrically connected to a detector circuit DC that serves to determine if the electric signal in a frequency range including characteristic switching frequency components received from the detector coil C deviates significantly from a normal value, such deviation indicating a possible magnetic Intrusion. Implementation examples of the detector circuit DC will be described in more details later.

The coil C should be positioned in relation to the transformer T, e.g. dose to its core, such that the magnetic dispersion field M in the air induces a voltage at the electric output of the coil C in the switching frequency range at an acceptable level in a typical magnetic intrusion situation. Hereby it is possible for the detector circuit DC to reliably detect a change in the magnetic dispersion field M without the significant influence of noise. The detector coil C may be attached directly to the transformer T, e.g. integrated with a casing around the transformer, the detector coil C may be attached to a casing around the entire meter, still further 5 the detector coil C may be mounted on a printed circuit board also carrying electronic circuit components related to the meter function.

The detector coil C is preferably oriented such in relation to the transformer T, that the magnetic dispersion field M from the transformer T in the magnetic intrusion situation induces the highest possible voltage level in the electric signal generated by the detector coil C. Thereby the most reliable detection of magnetic intrusion with a minimum influence of noise is obtained. The orientation of the detector coil C can e.g. be based on tests where the effect of a static magnetic field on the transformer T is taken into account, or on a test version of the transformer T where the inductive material is replaced by a material with significantly reduced inductive properties. The fact that it is possible to perform a test of the function of the detector coil C is advantageous over detection systems based on the detection of the intruding magnetic field, since e.g. the orientation of such intruding magnetic field is in general difficult to predict and therefore difficult to reliably detect by the use of one single transducer.

The size of the detector coil C may be in the range from 1 mm up to several centimetres. It is an advantage that the detector coil C can be positioned such that the input of the detector circuit DC is without galvanic contact with the switch mode supply.

In Fig. 1, the detector circuit DC applies a signal to a control circuit CC in case a change in the magnetic dispersion field M is detected. The control circuit CC can then perform an action accordingly. In the illustrated example, the control circuit CC controls a switch SW that connects the Radio Frequency transmitter RFT with the power supply PS. In response to the signal from the detector circuit DC, the control circuit CC can open the SW such that the rather power consuming Radio Frequency transmitter is disconnected from the power supply, and thus the power supply only needs to power the vital meter circuits MC and CA, thereby providing the possibility of acceptable operation during magnetic intrusion which reduces the capacity of the power supply PS. In addition to operating the switch SW, the control circuit CC may store information that can be read by the provider of the consumed entity, that magnetic intrusion has been detected, or the Radio Frequency transmitter RFT can be used to transmit a message to the provider informing about the magnetic intrusion. Still further, the control circuit CC may be arranged to cut off supply of the consumption entity if magnetic intrusion is detected.

Fig. 2 illustrates a diagram of a detector circuit DC embodiment based on detecting magnetic intrusion by the principle of comparing a level of the electric output of the detector coil at the switching frequency with a predetermined level. The detector coil C is connected to an input of the detector circuit DC which includes a tuning circuit TC in the form of a resistor and a capacitor in parallel with the detector coil C. The tuning circuit TC is tuned to emphasize a frequency band around the switching frequency of the switch mode power supply PS. An amplifier A serves to further amplify the signal from the tuning circuit TC, and the amplified signal is then applied to a filter F, e.g. in the form of a passive or active band pass filter serving to remove spectral components away from the frequency range including the switching frequency and related spectral components.

The filtered signal is then applied to a first level detector LD1, e.g. in the form of a rectifier which may be based on a diode. The rectified signal is then applied to a hold circuit H arranged to capture and hold the level of the signal steady. The output of the hold circuit is then applied to a second level detector LD2. The second level detector LD2 may be arranged only to detect one level, or it may be in the form of an analog-to-digital converter capable of discriminating between several levels. The output OUT of the detector circuit DC is finally the output of the second level detector LD2. In case the second level detector LD2 is an analog-to-digital converter, the output of the detector circuit DC is thus a digital signal suited for further processing e.g. by a main processor of the consumption meter. Alternatively, the output OUT of the detector circuit DC may be applied to a dedicated control circuit which is then arranged to initiate an appropriate action in response to detection of magnetic intrusion.

In the detector circuit DC of Fig. 2 the level where a change in the sensed magnetic field is obtained can be adjusted by adjusting the amplification in amplifier A. Thus, the final adjustment suited for a specific type of detector coil C and a specific position of the detector coil C in relation to the switch mode power supply PS is provided by an adjustable amplifier A.

In a simple implementation of the circuit of Fig. 2, the detector circuit DC only consists of the second level detector LD2 in the form of an analog-to-digital converter, possibly also with the tuning circuit TC. The digital output of the analog-to-digital converter can then be applied to further digital processing means, e.g. the main processor of the consumption meter, in order to determine if the level of the signal detected by the detector coil has passed a threshold indicating magnetic intrusion.

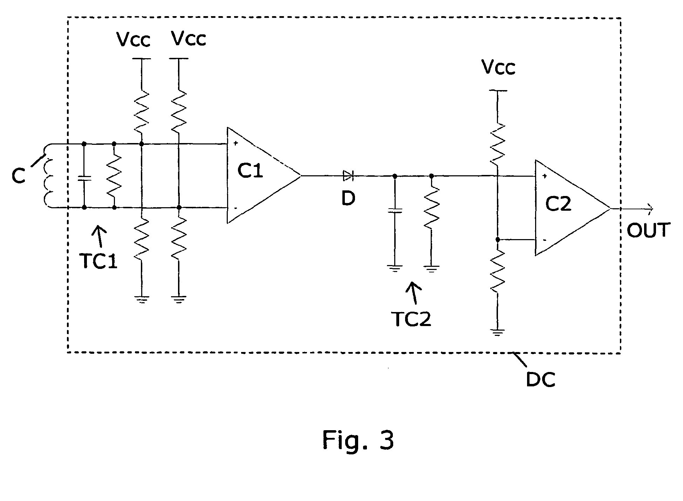

Fig. 3 shows a diagram of an alternative detector circuit DC connected to a detector coil C. As in Fig. 2, the input of the detector circuit DC includes a tuning circuit TC1 in the form of a parallel coupling of a capacitor and resistor selected to provide an emphasis on a frequency band containing the characteristic switching frequency components. Further, a network of resistors connected between electrical ground and a voltage source level Vcc are used to set the voltage level at the '+' and '-' inputs to a first comparator C1. The resistor network is selected such that the voltage levels set at the'+' and '-' inputs of the first comparator C1 ensure that: 1) an output of the first comparator C1 is 'low' when the detector coil C gives no signal or only a very low voltage signal at the input of the detector circuit DC, such as will be the case during normal operation of the switch mode power supply (PS), and 2) when the signal from the detector coil C reaches a certain threshold level, i.e. a level corresponding to what can be assumed during a magnetic intrusion situation, the first comparator C1 will give an output signal in response.

The output of the first comparator C1 is connected to a diode D serving to rectify the output signal before it is applied to a hold circuit TC2 in the form of a parallel coupling of a capacitor and a resistor connecting the output of the diode D to electrical ground. The capacitor in the hold circuit TC2 is charged via the diode and discharged via the resistor of the hold circuit TC2. This resistor should be selected such that the discharging of the capacitor is much slower than the charging via the diode D. Hereby, the signal at the '+' input of a second comparator C2 has a low frequency compared to the output of the first comparator C1. A '-' input of the second comparator C2 has a fixed voltage level set by a resistor network connected between the voltage source Vcc and electrical ground. The output of the second comparator C2 forms the output OUT of the detector circuit DC, and this output OUT corresponds to a level of the hold circuit TC2. The output OUT can then be applied for further processing in the consumption meter, e.g. in a control circuit arranged to initiate an action according to the output signal OUT.

In principle, the output of the first comparator C1 could be directly applied to a control circuit, provided that the control circuit has the necessary capacity to read this output signal fast enough.

To sum up, the invention provides a consumption meter having a magnet detector to be able to detect magnetic intrusion. The meter includes a measurement circuit (MC) and a calculator circuit (CA) which are both powered by a switch mode power supply (PS) operating according to an electric switching scheme typically characterized by certain switching frequency components. A detector coil (C), preferably an air coil, is arranged in relation to the switch mode power supply (PS) so as to sense a magnetic field (M) related to the switching operation of the switch mode power supply, e.g. a magnetic field (M) in a frequency range including at least some of the characteristic switching frequency components. The detector coil (C) is preferably positioned near an inductive element, e.g. a transformer (T), of the power supply (PS) to catch an increase in the magnetic field (M) from the transformer (T) caused by magnetic intrusion. A detector circuit DC detects a change in the electric signal from the detector coil C. With this approach, a magnetic intrusion effect on the power supply PS is detected rather than detecting a magnetic field from an unknown intruding magnet. Hereby it is possible to catch every attempt to magnetically destroy the function of power supply PS and thereby destroy the vital meter function. Based on an output from the detector circuit DC an appropriate action can be initiated by the meter, e.g. by means of a control circuit CC serving to switch off power supply to non-vital circuits in the meter, such as a radio transmitter RFT, when magnetic intrusion is detected. The detector circuit DC can be implemented by means of simple comparator circuits serving to compare the electric output of the detector coil C with a threshold value.

## Claims

1. A consumption meter for measuring a quantity value (Q) corresponding to a consumed quantity, the consumption meter including
- a measurement circuit (MC) arranged to measure a physical quantity related to the consumed quantity and to generate measurement data accordingly,
- a calculator circuit (CA) arranged to calculate the quantity value (Q) in response to the measurement data,
- a switch mode power supply (PS) for powering at least the measurement circuit (MC) and the calculator circuit (CA), the switch mode power supply (PS) involving an electrical switching operation and comprising an inductive element (T),
**characterized in that**
the consumption meter further comprises
- a magnetic field detector including
- a detector coil (C) of electrically conducting material, the coil being positioned in relation to the inductive element of the switch mode power supply (PS) so as to sense a magnetic field (M) related to the electrical switching operation of the switch mode power supply (PS) by sensing a magnetic field (M) radiated from the indutive element (T), and generate an electric signal accordingly, and
- a detector circuit (DC) electrically connected to the detector coil (C) to detect a change in the electric signal from the detector coil (C) as indication of an external magnetic influence of the consumption meter.

2. Meter according to claim 1, wherein the detector circuit (DC) is arranged to generate an output signal upon detection of a level of the electric signal in a frequency range including at least one frequency component related to the switching operation of the switch mode power supply (PS) exceeding a predetermined threshold.

3. Meter according to any of the preceding claims, wherein the detector circuit (DC) applies the electric signal from the detector coil (C) to a tuning circuit (TC, TC1) tuned to a frequency range characteristic for the switching operation of the switch mode power supply (PS).

4. Meter according to claim 3, wherein an output from the tuning circuit (TC, TC1) is applied to a comparator (LD1, C1) arranged to compare a level of the output from the tuning circuit (TC, TC1) to a predetermined level.

5. Meter according to any of the preceding claims, including a filter (F) arranged to suppress spectral components in the electric signal away from a frequency range characteristic for the switching operation of the switch mode power supply (PA).

6. Meter according to any of the preceding claims, including a control circuit (CC) operationally connected to the detector circuit (DC), and wherein the control circuit (CC) is arranged to initiate an action in response to a change in the electric signal from the detector coil (C) being detected by the detector circuit (DC).

7. Meter according to claim 6, wherein the control circuit (CC) is arranged to disconnect auxiliary circuits (RFT) from the switch mode power supply (PS) in response to a change in the electric signal from the detector coil (C).

8. Meter according to claim 6 or 7, wherein the control circuit (CC) is arranged to generate an alarm signal, such as a visual or audible alarm signal, in response to a change in the electric signal from the detector coil (C).

9. Meter according to any of claims 6-8, wherein the control circuit (CC) is arranged to interrupt supply of the consumption entity in response to a change in the electric signal from the detector coil (C).

10. Meter according to any of claims 6-9, wherein the control circuit (CC) is arranged to store data in a memory of the meter indicating that a change in the electric signal from the detector coil (C) has been detected, such as data including a time information associated therewith.

11. Meter according to any of the preceding claims, further including a communication module arranged to transmit a data value representing the consumed quantity.

12. Meter according to claim 11, wherein the communication module includes a wireless Radio Frequency transmitter (RFT).

13. Meter according to claims 11 or 12, wherein the communication module is arranged to transmit an alarm signal upon change in the electric signal from the detector coil (C) being detected.

14. An electricity meter according to any of claims 1-13, arranged to measure a quantity of one of: electric energy, heat, water, and gas.

15. A method for detecting an external magnetic influence of a consumption meter arranged to measure a quantity of a consumption entity, the method including
- arranging a detector coil of electrically conducting material in relation to a switch mode power supply powering at least a part of the consumption meter, the switch mode power supply comprises an inductive element, the detector coil being positioned in relation to the inductive element of the switch mode power supply so as to sense a magnetic field related to switching operation of the switch mode power supply by sensing a magnetic field radiated from the inductive element, and generate an electric signal accordingly, and
- detecting a change in the electric signal from the detector coil as indication of an external magnetic influence of the consumption meter.

## Patentansprüche

1. Verbrauchsmessgerät zum Messen eines Mengenwerts (Q), der einer verbrauchten Menge entspricht, wobei das Verbrauchsmessgerät umfasst
- einen Messschaltkreis (MC), angeordnet zum Messen einer physikalischen Menge, die in Bezug zu der verbrauchten Menge steht, und zum entsprechenden Erzeugen von Messdaten,
- einen Rechenschaltkreis (CA), angeordnet zum Berechnen des Mengenwerts (Q) als Reaktion auf die Messdaten,
- ein Schaltnetzteil (PS) zur Stromversorgung mindestens des Messschaltkreises (MC) und des Rechenschaltkreises (CA), wobei das Schaltnetzteil (PS) einen elektrischen Schaltvorgang beinhaltet und ein induktives Bauteil (T) umfasst,
**dadurch gekennzeichnet, dass** das Verbrauchsmessgerät weiterhin umfasst
- einen Magnetfelddetektor, umfassend
- eine Detektorspule (C) aus elektrisch leitfähigem Material, wobei die Spule derart in Bezug auf das induktive Bauteil des Schaltnetzteils (PS) angebracht ist, dass sie ein Magnetfeld (M) erfasst, das in Bezug zu dem elektrischen Schaltvorgang des Schaltnetzteils (PS) steht, indem sie ein Magnetfeld (M) erfasst, das von dem induktiven Bauteil (T) abgestrahlt wird, und ein entsprechendes elektrisches Signal erzeugt, und
- einen elektrisch mit der Detektorspule (C) verbundenen Detektorschaltkreis (DC) zum Erfassen einer Änderung des elektrischen Signals der Detektorspule (C) als Anzeichen einer externen magnetischen Beeinflussung des Verbrauchsmessgeräts.

2. Messgerät nach Anspruch 1, wobei der Detektorschaltkreis (DC) derart angeordnet ist, dass er nach Erfassen eines einen vorgegebenen Schwellwert überschreitenden Pegels des elektrischen Signals in einem Frequenzbereich, der mindestens eine Frequenzkomponente umfasst, die in Bezug zu dem Schaltvorgang des Schaltnetzteils (PS) steht, ein Ausgangssignal erzeugt.

3. Messgerät nach einem der vorhergehenden Ansprüche, wobei der Detektorschaltkreis (DC) das elektrische Signal der Detektorspule (C) an einem Abstimmschaltkreis (TC, TC1) anlegt, der auf einen Frequenzbereich eingestellt ist, der für den Schaltvorgang des Schaltnetzteils (PS) charakteristisch ist.

4. Messgerät nach Anspruch 3, wobei ein Ausgang des Abstimmschaltkreises (TC, TC1) mit einem Komparator (LD1, C1) verbunden ist, der derart angeordnet ist, dass er einen Pegel am Ausgang des Abstimmschaltkreises (TC, TC1) mit einem vorbestimmten Pegel vergleicht.

5. Messgerät nach einem der vorhergehenden Ansprüche, umfassend ein Filter (F) das derart angeordnet ist, dass es Spektralanteile des elektrischen Signals außerhalb eines Frequenzbereichs unterdrückt, der für den Schaltvorgang des Schaltnetzteils (PS) charakteristisch ist.

6. Messgerät nach einem der vorhergehenden Ansprüche, umfassend einen Steuerschaltkreis (CC), der wirksam mit dem Detektorschaltkreis (DC) verbunden ist, und wobei der Steuerschaltkreis (CC) derart angeordnet ist, dass er eine Aktion als Reaktion auf eine vom Detektorschaltkreis (DC) erfasste Änderung des elektrischen Signals der Detektorspule (C) einleitet.

7. Messgerät nach Anspruch 6, wobei der Steuerschaltkreis (CC) derart angeordnet ist, dass er als Reaktion auf eine Änderung des elektrischen Signals der Detektorspule (C) Hilfsschaltkreise (RFT) vom Schaltnetzteil (PS) trennt.

8. Messgerät nach Anspruch 6 oder 7, wobei der Steuerschaltkreis (CC) derart angeordnet ist, dass er als Reaktion auf eine Änderung des elektrischen Signals der Detektorspule (C) ein Alarmsignal, wie ein sichtbares oder hörbares Alarmsignal, erzeugt.

9. Messgerät nach einem der Ansprüche 6-8, wobei der Steuerschaltkreis (CC) derart angeordnet ist, dass er als Reaktion auf eine Änderung des elektrischen Signals der Detektorspule (C) die Versorgung der Verbrauchseinheit unterbricht.

10. Messgerät nach einem der Ansprüche 6-9, wobei der Steuerschaltkreis (CC) derart angeordnet ist, dass er Daten in einem Speicher des Messgeräts speichert, die anzeigen, dass eine Änderung des elektrischen Signals der Detektorspule (C) erfasst wurde, wie Daten einschließlich damit verbundener zeitbezogener Informationen.

11. Messgerät nach einem der vorhergehenden Ansprüche, weiterhin umfassend ein Kommunikationsmodul, das derart angeordnet ist, dass es einen Datenwert, der die verbrauchte Menge repräsentiert, überträgt.

12. Messgerät nach Anspruch 11, wobei das Kommunikationsmodul einen drahtlosen Hochfrequenzsender (RFT) umfasst.

13. Messgerät nach Anspruch 11 oder 12, wobei das Kommunikationsmodul derart angeordnet ist, dass es nach dem Erfassen einer Änderung des elektrischen Signals der Detektorspule (C) ein Alarmsignal sendet.

14. Messgerät nach einem der Ansprüche 1-13, derart angeordnet, dass es eine Menge von entweder: elektrischer Energie, Wärme, Wasser oder Gas misst.

15. Verfahren zum Erfassen einer externen magnetischen Beeinflussung eines Verbrauchsmessgeräts, das derart angeordnet ist, dass es eine Menge einer Verbrauchseinheit misst, wobei das Verfahren umfasst
- Anordnen einer Detektorspule aus elektrisch leitfähigem Material in Bezug zu einem Schaltnetzteil zur Stromversorgung mindestens eines Teils des Verbrauchsmessgeräts, wobei das Schaltnetzteil ein induktives Bauteil umfasst, wobei die Detektorspule derart in Bezug auf das induktive Bauteil des Schaltnetzteils angebracht ist, dass sie ein Magnetfeld erfasst, das in Bezug zu dem elektrischen Schaltvorgang des Schaltnetzteils steht, indem sie ein Magnetfeld erfasst, das von dem induktiven Bauteil abgestrahlt wird, und ein entsprechendes elektrisches Signal erzeugt, und
- Erfassen einer Änderung des elektrischen Signals der Detektorspule als Anzeichen einer externen magnetischen Beeinflussung des Verbrauchsmessgeräts.

## Revendications

1. Compteur de consommation destiné à mesurer une valeur quantitative (Q) correspondant à une quantité consommée, le compteur de consommation comportant
- un circuit de mesure (MC) conçu pour mesurer une quantité physique relative à la quantité consommée et pour générer des données de mesure correspondantes,
- un circuit de calcul (CA) conçu pour calculer la valeur quantitative (Q) en réponse aux données de mesure,
- une alimentation électrique à découpage (PS) destinée à alimenter au moins le circuit de mesure (MC) et le circuit de calcul (CA), l'alimentation électrique à découpage (PS) faisant intervenir un fonctionnement par découpage, et comprenant un élément inducteur (T), **caractérisé en ce que** le compteur de consommation comprend également
- un détecteur de champ magnétique comportant
- une bobine détectrice (C) constituée d'un matériau électroconducteur, la bobine étant positionnée par rapport à l'élément inducteur de l'alimentation électrique à découpage (PS) de manière à détecter un champ magnétique (M) lié au fonctionnement par découpage de l'alimentation électrique à découpage (PS) en détectant un champ magnétique (M) émanant de l'élément inducteur (T), et à générer un signal électrique correspondant, et
- un circuit détecteur (DC) raccordé électriquement à la bobine détectrice (C) pour détecter une modification du signal électrique provenant de la bobine détectrice (C) indiquant une influence magnétique externe au compteur de consommation.

2. Compteur selon la revendication 1, dans lequel le circuit détecteur (DC) est conçu pour générer un signal de sortie lorsqu'il détecte un niveau du signal électrique situé dans une gamme de fréquences comportant au moins une composante de fréquence liée au fonctionnement par découpage de l'alimentation électrique à découpage (PS) dépassant un seuil prédéterminé.

3. Compteur selon l'une quelconque des revendications précédentes, dans lequel le circuit détecteur (DC) applique le signal électrique provenant de la bobine détectrice (C) à un circuit d'accord (TC, TC1) accordé sur une gamme de fréquences caractéristique du fonctionnement par découpage de l'alimentation électrique à découpage (PS).

4. Compteur selon la revendication 3, dans lequel un signal produit par le circuit d'accord (TC, TC1) est appliqué à un comparateur (LD1, C1) conçu pour comparer un niveau du signal produit par le circuit d'accord (TC, TC1) à un niveau prédéterminé.

5. Compteur selon l'une quelconque des revendications précédentes, comportant un filtre (F) conçu pour éliminer les composantes spectrales du signal électrique se situant en dehors d'une gamme de fréquences caractéristique du fonctionnement par découpage de l'alimentation électrique à découpage (PS).

6. Compteur selon l'une quelconque des revendications précédentes, comportant un circuit de commande (CC) raccordé de façon opérationnelle au circuit détecteur (DC), et dans lequel le circuit de commande (CC) est conçu pour initier une action en réponse à une modification du signal électrique provenant de la bobine détectrice (C) ayant été détectée par le circuit détecteur (DC).

7. Compteur selon la revendication 6, dans lequel le circuit de commande (CC) est conçu pour déconnecter des circuits auxiliaires (RFT) de l'alimentation électrique à découpage (PS) en réponse à une modification du signal électrique provenant de la bobine détectrice (C).

8. Compteur selon la revendication 6 ou 7, dans lequel le circuit de commande (CC) est conçu pour générer un signal d'alarme, tel qu'un signal d'alarme visuel ou sonore, en réponse à une modification du signal électrique provenant de la bobine détectrice (C).

9. Compteur selon l'une quelconque des revendications 6 à 8, dans lequel le circuit de commande (CC) est conçu pour interrompre l'alimentation de l'entité consommatrice en réponse à une modification du signal électrique provenant de la bobine détectrice (C).

10. Compteur selon l'une quelconque des revendications 6 à 9, dans lequel le circuit de commande (CC) est conçu pour stocker dans une mémoire du compteur des données indiquant qu'une modification du signal électrique provenant de la bobine détectrice (C) a été détectée, telles que des données incluant une information temporelle associée à celle-ci.

11. Compteur selon l'une quelconque des revendications précédentes, comportant également un module de communication conçu pour transmettre une valeur de donnée représentant la quantité consommée.

12. Compteur selon la revendication 11, dans lequel le module de communication comprend un transmetteur radioélectrique sans fil (RFT).

13. Compteur selon l'une quelconque des revendications 11 ou 12, dans lequel le module de communication est conçu pour transmettre un signal d'alarme en cas de détection d'une modification du signal électrique provenant de la bobine détectrice (C).

14. Compteur électrique selon l'une quelconque des revendications 1 à 13, conçu pour mesurer l'une des quantités suivantes : énergie électrique, chaleur, eau et gaz.

15. Méthode de détection d'une influence magnétique externe à un compteur de consommation conçue pour mesurer une quantité d'une entité consommatrice, la méthode comportant les étapes suivantes :
- mise en place d'une bobine détectrice constituée d'un matériau électroconducteur en rapport avec une alimentation électrique à découpage alimentant au moins une partie du compteur de consommation, l'alimentation électrique à découpage comprenant un élément inducteur, la bobine détectrice étant positionnée par rapport à l'élément inducteur de l'alimentation électrique à découpage de manière à détecter un champ magnétique lié au fonctionnement par découpage de l'alimentation électrique à découpage en détectant un champ magnétique émanant de l'élément inducteur, et à générer un signal électrique correspondant, et
- détection d'une modification du signal électrique provenant de la bobine détectrice indiquant une influence magnétique externe au compteur de consommation.
